# EUROPEAN PATENT APPLICATION

(11) **EP 4 528 973 A2**
(43) Date of publication of application: **26.03.2025**
(21) Application number: 24196772.8
(22) Date of filing: 27.08.2024
(51) Int. Cl.: H02J 7/00, G01R 31/66

(54) **ENERGY STORAGE DEVICE, METHOD FOR ENERGY STORAGE DEVICE TO DETERMINE WHETHER CONVERTER DEVICE CONNECTED THERETO HAS NEUTRAL LINE, AND POWER SUPPLY SYSTEM**

(30) Priority: 28.08.2023 CN 202311090950
(71) Applicant: KEHUA DATA CO., LTD., Xiamen, Fujian 361101 (CN); ZHANGZHOU KEHUA ELECTRIC TECHNOLOGY CO., LTD., Zhangzhou Fujian 363000 (CN)
(72) Inventor: ZHONG, Weilong, Xiamen 361101 (CN); ZHANG, Tinggang, Xiamen 361101 (CN); ZHENG, Weilong, Xiamen 361101 (CN); YANG, Xin, Xiamen 361101 (CN)
(74) Representative: Regimbeau

(57) **Abstract**

The invention provides an energy storage device, a method for an energy storage device to determine whether a converter device connected thereto has a neutral line, and a power supply system. The energy storage device includes a connection terminal, a neutral line switch, an energy storage unit and a control unit. The control unit is adapted to: obtain, when the energy storage device is in a shutdown state and the converter device is in a state of charging the energy storage device, two port voltages of the energy storage device when a preset condition is satisfied, and determine whether a change of a voltage difference between the two port voltages is within a preset range when the preset condition is satisfied. If the result is yes, the neutral line switch is controlled to be switched on; otherwise, the neutral line switch is controlled to be switched off. The disclosure may detect whether the converter device has the neutral line and thereby create a condition for automated operation of the energy storage device.

## Description

### TECHNICAL FIELD

The disclosure relates to the field of power supply, and in particular to an energy storage device, a method for an energy storage device to determine whether a converter device connected thereto has a neutral line, and a power supply system.

### BACKGROUND

As a power supply system, in an uninterruptible power supply, an energy storage device and a converter device are connected. The energy storage device is charged through the converter device when the utility power is normal, and direct-current (DC) power of the energy storage device is converted to the utility power through the converter device when the utility power is abnormal.

The converter unit is available in two models, one with a neutral line and the other without the neutral line. In order to match different models of converter devices, the energy storage device is generally configured with a neutral line output terminal. When the converter device has the neutral line, a positive terminal, a negative terminal and a neutral line terminal of the converter device are respectively connected to a positive output terminal, a negative output terminal, and the neutral line output terminal of the energy storage device. When the converter device does not have the neutral line, the positive terminal and the negative terminal of the converter device are respectively connected to the positive output terminal and the negative output terminal of the energy storage device. Therefore, operation of the energy storage device varies when the converter device has the neutral line or does not have the neutral line. In a practical application, cables of the converter device and the energy storage device would be connected in advance, but the energy storage device can not automatically identify whether the converter device has the neutral line. An on-site user needs to manually turn on the energy storage device and control its operation after determining whether there is the neutral line, which cannot achieve the automatic operation, and is time-consuming and laborious.

### SUMMARY

The purpose of the disclosure is to overcome the above defects or problems described in the background, and to provide an energy storage device, a method for an energy storage device to determine whether a converter device connected thereto has a neutral line, and a power supply system, which may detect whether the converter device has the neutral line, thereby creating a condition for the automatic operation of the energy storage device.

In order to achieve the above purpose, the disclosure and relevant embodiments thereof adopt the following technical solutions, but are not limited thereto.

A first technical solution and relevant embodiments thereof relate to an energy storage device including a connection terminal, a neutral line switch, an energy storage unit and a control unit. The connection terminal includes a positive output terminal, a negative output terminal and a neutral line output terminal. The energy storage unit is adapted to be connected to the positive output terminal and the negative output terminal, and is further adapted to be connected to the neutral line output terminal through the neutral line switch. The control unit is adapted to: obtain, when the energy storage device is in a shutdown state and the converter device is in a state of charging the energy storage device, two port voltages of the energy storage device when a preset condition is satisfied, and determine whether a change of a voltage difference between the two port voltages is within a preset range when the preset condition is satisfied. If the result is yes, the neutral line switch is controlled to be switched on; otherwise, the neutral line switch is controlled to be switched off. The port voltages are voltages between the neutral line output terminal and the positive output terminal or voltages between the neutral line output terminal and the negative output terminal.

A second technical solution is based on the first technical solution and is a preferred embodiment of the first technical solution. In the second technical solution, the energy storage device further includes a voltage collector. Either the positive output terminal or the negative output terminal is defined as a detection output terminal. The two port voltages are respectively a maximum voltage value and a minimum voltage value between the neutral line output terminal and the detection output terminal detected by the voltage collector during a set period. If a difference between the maximum voltage value and the minimum voltage value is within the preset range, the neutral line switch is controlled to be switched on; otherwise, the neutral line switch is controlled to be switched off.

A third technical solution is based on the first technical solution and is a preferred embodiment of the first technical solution. In the third technical solution, the energy storage device further includes a voltage collector and a voltage dividing unit. Either the positive output terminal or the negative output terminal is defined as the detection output terminal, and either the positive output terminal or the negative output terminal is defined as a connection output terminal. The voltage dividing unit is connected in series between the neutral line output terminal and the connection output terminal, and is adapted to establish a path between the neutral line output terminal and the connection output terminal. The two port voltages are respectively a first voltage between the neutral line output terminal and the detection output terminal, which is detected by the voltage collector when the path between the neutral line output terminal and the connection output terminal exists, and a second voltage between the neutral line output terminal and the detection output terminal, which is detected by the voltage collector when the path between the neutral line output terminal and the connection output terminal does not exist. If a difference between the first voltage and the second voltage is within the preset range, the neutral line switch is switched on; otherwise, the neutral line switch is switched off.

A fourth technical solution is based on the third technical solution and is a preferred embodiment of the third technical solution. In the fourth technical solution, the voltage dividing unit includes a voltage dividing resistor and a voltage dividing switch connected in series. The voltage dividing switch establishes the path between the neutral line output terminal and the connection output terminal when the voltage dividing switch is switched on, and the path between the neutral line output terminal and the connection output terminal does not exist when the voltage dividing switch is switched off.

A fifth technical solution is based on the fourth technical solution and is a preferred embodiment of the fourth technical solution. In the fifth technical solution, when the detection output terminal is the positive output terminal, if the connection output terminal is the positive output terminal, the first voltage is less than the second voltage, and the difference between the first voltage and the second voltage is not within the preset range, the control unit controls the neutral line switch to be switched off; otherwise, the control unit controls the neutral line switch to be switched on. If the connection output terminal is the negative output terminal, the first voltage is greater than the second voltage, and the difference between the first voltage and the second voltage is greater than a first threshold, the control unit controls the neutral line switch to be switched off; otherwise, the control unit controls the neutral line switch to be switched on. When the detection output terminal is the negative output terminal, if the connection output terminal is the positive output terminal, the first voltage is greater than the second voltage, and the difference between the first voltage and the second voltage is greater than the first threshold, the control unit controls the neutral line switch to be switched off; otherwise, the control unit controls the neutral line switch to be switched on. If the connection output terminal is the negative output terminal, the first voltage is less than the second voltage, and the difference between the first voltage and the second voltage is greater than the first threshold, the control unit controls the neutral line switch to be switched off; otherwise, the control unit controls the neutral line switch to be switched on.

A sixth technical solution is based on any one of the second to fifth technical solutions, and is a preferred embodiment of the second to fifth technical solutions. In the sixth technical solution, the energy storage unit includes a first DC power supply module and a second DC power supply module with equal voltages. The first DC power supply module and the second DC power supply module are adapted to be connected in series or in parallel. The neutral line switch is connected in series between a negative terminal of the first DC power supply module and the neutral line output terminal, or between a positive terminal of the second DC power supply module and the neutral line output terminal. The control unit is further adapted to switch on the neutral line switch when the first DC power supply module and the second DC power supply module are connected in series and it is determined that the converter device has a neutral line.

A seventh technical solution is based on the sixth technical solution and is a preferred embodiment of the sixth technical solution. In the seventh technical solution, the energy storage unit further includes a series-parallel switch module. The series-parallel switch module includes a first switch for connecting the first DC power supply module and the second DC power supply module in series, a second switch for connecting a positive terminal of the first DC power supply module and the positive terminal of the second DC power supply module in parallel, and a third switch for connecting the negative terminal of the first DC power supply module and a negative terminal of the second DC power supply module in parallel. The control unit is adapted to obtain an operating voltage and an operating current of the converter device, and control, when the operating voltage is greater than a first set value and the energy storage device is in a discharge state, the first switch to be switched on to connect the first DC power supply module and the second DC power supply module in series. The control unit further controls, when the operating current is greater than a second set value and the energy storage device is in the discharge state, the second switch and the third switch to be switched on to connect the first DC power supply module and the second DC power supply module in parallel.

An eighth technical solution is based on the seventh technical solution and is a preferred embodiment of the seventh technical solution. In the eighth technical solution, the first DC power supply module includes N first DC power supply sub-modules, the second DC power supply module includes M second DC power supply sub-modules, and N and M are positive integers. The series-parallel switch module includes, when N is greater than 1, a fourth switch unit for achieving series connection of the first DC power supply sub-modules and a fifth switch unit for achieving parallel connection of the first DC power supply sub-modules. The series-parallel switch module includes, when M is greater than 1, a seventh switch unit for achieving series connection of the second DC power supply sub-modules and an eighth switch unit for achieving parallel connection of the second DC power supply sub-modules. When the operating voltage is greater than the second set value, the energy storage device is in the discharge state and N is greater than 1, the control unit controls the number of the first DC power supply sub-modules and the second DC power supply sub-modules to be connected according to the operating voltage. When the operating current is greater than the first set value, the energy storage device is in the discharge state and M is greater than 1, the control unit controls the number of the first DC power supply sub-modules and the second DC power supply sub-modules to be connected according to the operating current. The control unit is adapted to shut down the energy storage unit when an operation requirement of the converter device changes, and switch, after a set period according to obtained information, a connection manner of the first DC power supply module and the second DC power supply module, a connection manner of the first DC power supply sub-modules, a connection manner of the second DC power supply sub-modules, and switching-on and switching-off of the neutral line switch.

A ninth technical solution relates to a method for an energy storage device to determine whether a converter device connected thereto has a neutral line. The energy storage device is provided with a positive output terminal, a negative output terminal and a neutral line output terminal. The method includes the following operations. A wiring between the energy storage device and the converter device is completed. When the energy storage device is in a shutdown state and the converter device is in a state of charging the energy storage device, two port voltages of the energy storage device when a preset condition is satisfied are obtained, and it is determined whether a change of a voltage difference between the two port voltages is within a preset range when the preset condition is satisfied. If the result is yes, the neutral line switch is controlled to be switched on; otherwise, the neutral line switch is controlled to be switched off. The port voltages are voltages between the neutral line output terminal and the positive output terminal or voltages between the neutral line output terminal and the negative output terminal.

A tenth technical solution and relevant embodiments thereof relates to a power supply system including a converter device and an energy storage device of any one of the first to eighth technical solutions. The converter device is a first converter device or a second converter device electrically coupled to the energy storage device. The first converter device includes a neutral potential point, and the second converter device does not include the neutral potential point.

As can be seen from the above description of the disclosure and specific embodiments thereof, compared to the related art, the technical solutions of the disclosure and relevant embodiments thereof have the following beneficial effects by adopting the following technical means.

From continuous observation, experimentation and research, the applicant knows that in the existing technical solutions, the reason for the technical problem that the energy storage device cannot operate automatically is that the energy storage device cannot determine whether the converter device has the neutral line and thus manual intervention in the energy storage device is required after it is determined whether the converter device has the neutral line.

In the first technical solution and the relevant embodiments thereof, the wiring of the energy storage device and the converter device is firstly completed. At this time, since the energy storage device does not know whether the converter device has the neutral line, the energy storage device is in the shutdown state to ensure output safety of the energy storage device. The energy storage device is charged through the converter device, and the output terminal of the energy storage device is also electrified. The two port voltages of the energy storage device are obtained when the preset condition is satisfied, and it is determined whether the change of the voltage difference between the two port voltages is within the preset range when the preset condition is satisfied. If the result is yes, it is determined that the converter device has the neutral line and the neutral line switch is controlled to be switched on; otherwise, the converter device does not have the neutral line and the neutral line switch is controlled to be switched off. The port voltages are the voltages between the neutral line output terminal and the positive output terminal, or the voltages between the neutral line output terminal and the negative output terminal. The reason is as follows. When the converter device has the neutral line, the positive and negative voltages of the converter device are controlled separately, and the port voltages are basically unchanged. When the converter device does not have the neutral line, the difference between the positive and negative voltages of the converter device is stable, and thus the port voltages would change to different degrees under different detection conditions. Therefore, it may be determined whether the converter device has the neutral line by detecting the change of the port voltages under different conditions. The neutral line switch would be switched on after the neutral line has been detected, and thus the neutral line output terminal of the energy storage device is conductive; otherwise, the neutral line output terminal is not conductive. In this way, the energy storage device may match the converter device with the neutral line and the converter device without the neutral line, so that the energy storage device may be automatically adapted to different types of converter devices after operation. It is to be understood by those skilled in the art that when the neutral line switch is switched on, the voltage between the positive output terminal and the neutral line output terminal is equal to the voltage between the neutral line output terminal and the negative output terminal.

In the second technical solution and the relevant embodiments thereof, when the converter device has the neutral line, the port voltage between the neutral line output terminal and the detection output terminal is basically unchanged, that is, the maximum voltage value and the minimum voltage value are basically equal within the set period. When the converter device does not have the neutral line, the voltage between the neutral line output terminal and the detection output terminal fluctuates, that is, there exist a maximum voltage value and a minimum voltage value within the set period, and the difference between the two would exceed the preset range. In this way, it may be determined that the converter device does not have the neutral line and thus the neutral line switch is switched off. Such determination method is simple and easy to implement.

In the third technical solution and the relevant embodiments thereof, the first voltage between the neutral line output terminal and the detection output terminal of the energy storage device when the path between the neutral line output terminal and the connection output terminal exists, and the second voltage between the neutral line output terminal and the detection output terminal of the energy storage device when the path between the neutral line output terminal and the connection output terminal does not exist, are detected. If the difference between the first voltage and the second voltage exceeds the preset range, it is determined that the converter device connected thereto does not have the neutral line; otherwise, the converter device has the neutral line. The reason is as follows. When the converter device has the neutral line, the positive and negative voltages of the converter device are controlled separately, and thus the detected voltage between the neutral line output terminal and the detection output terminal does not change whether or not the path between the neutral line output terminal and the connection output terminal exists. When the converter device does not have the neutral line, the difference between the positive and negative voltages of the converter device is stable, a leakage current would be formed after the path between the neutral line output terminal and the connection output terminal is formed, so that the voltage corresponding to the detection output terminal changes. Therefore, the energy storage device may determine whether the converter device connected thereto has the neutral line by comparing the change of the difference between the first voltage and the second voltage, and thus control the neutral line switch to be switched on or off. Such determination method is simple to operate and easy to implement. When the difference between the first voltage and the second voltage is compared, both the first voltage and the second voltage correspond to the detection output terminal. However, the connection output terminal and the detection output terminal may be the same or different. The reason is as follows. When the converter device does not have the neutral line, the change of the voltage of the positive output terminal is necessarily accompanied by the change of the voltage of the negative output terminal. Therefore, even if the detection output terminal and the connection output terminal are different, it is still possible to determine whether there is a change before and after the existence of the path corresponding to the connection output terminal. The voltage dividing unit is disposed to establish the path between the neutral line output terminal and the connection output terminal, which is inexpensive, easy to operate and safe to use.

In the fourth technical solution and the relevant embodiments thereof, the path is formed by switching on the voltage dividing switch, and the path is disconnected by switching off the voltage dividing switch, which are easy to control.

In the fifth technical solution and the relevant embodiments thereof, several determination cases are described where the connection output terminal and the detection output terminal are the same and different, and the change of the voltage may be detected for each case. When the detection output terminal is the positive output terminal, if the connection output terminal is the positive output terminal, the positive voltage decreases due to the leakage current after the path is formed, so that the first voltage is less than the second voltage; if the connection output terminal is the negative output terminal, the negative voltage decreases due to the leakage current after the path is formed, so that the voltage between the neutral line output terminal and the negative output terminal decreases. Since the difference between the positive voltage and the negative voltage is unchanged, the positive voltage increases, so that the first voltage is greater than the second voltage. When the detection output terminal is the negative output terminal, if the connection output terminal is the positive output terminal, the positive voltage decreases due to the leakage current after the path is formed. Since the difference between the positive voltage and the negative voltage does not change, the voltage between the neutral line output terminal and the negative output terminal increases, so that the first voltage is greater than the second voltage; if the connection output terminal is the negative output terminal, the negative voltage decreases due to the leakage current after the path is formed, so that the voltage between the neutral line output terminal and the negative output terminal decreases, and the first voltage is less than the second voltage.

In the sixth technical solution and the relevant embodiments thereof, the control unit is further adapted to switch on the neutral line switch when the first DC power supply module and the second DC power supply module are connected in series and it is determined that the converter device has the neutral line, which ensures the automatic operation of the energy storage device.

In the seventh technical solution and the relevant embodiments thereof, the control unit controls series-parallel switching of the first DC power supply module and the second DC power supply module according to the operating voltage and operating current of the converter device, so that the energy storage device may further be adapted to the operation requirement of the converter device. Compared to manually adjusting series-parallel connection of the first DC power supply module and the second DC power supply module, the energy storage device may switch in real time, and operation is more flexible. When the converter device requires a large voltage, the first DC power supply module and the second DC power supply module are connected in series by controlling the first switch to be switched on, which enables the energy storage device to output a large output voltage. When the converter device not only requires the large voltage but also has the neutral line, the first DC power supply module and the second DC power supply module are connected in series by controlling the first switch to be switched on, and the neutral line switch is switched on, so that the energy storage device is enabled to output a large output voltage and to have the neutral line. When the converter device requires a large current, the first DC power supply module and the second DC power supply module are connected in parallel by controlling the second switch and the third switch to be switched on, which enables the energy storage device to output the large output current.

In the eighth technical solution and the relevant embodiments thereof, for different operation requirements of the converter device (e.g. the converter device requires a large voltage but the value of the large voltage is not the same, and the converter device requires a large current but the value of the large current is not the same), as long as it is ensured that voltages of the first DC power supply module and the second DC power supply module are equal, the first DC power supply module may be enabled to have different output currents and output voltages by combining series-parallel connection of the first DC power supply sub-modules in the first DC power supply module, and the second DC power supply module may also be enabled to have different output currents and output voltages by combining series-parallel connection of the second DC power supply sub-modules in the second DC power supply module. For example, when the first DC power supply module includes four first DC power supply sub-modules, the four first DC power supply sub-modules may be connected in series by the fourth switch unit to output a first voltage value. Alternatively, two of the four first DC power supply sub-modules may be connected in series as a group by the cooperation of the fourth switch unit and the fifth switch unit, and then the two groups may be connected in parallel to form the first DC power supply module having a second voltage value. Alternatively, only one or two first DC power supply sub-modules are connected according to the requirement of the converter device. Therefore, the eighth technical solution may further satisfy a variety of operation requirements of the converter device. When the converter device is replaced, the requirement of the converter device would change. In such case, firstly, the energy storage unit is shut down, and after determining the configuration and requirement of the converter device, the control unit performs control to switch the connection manner of the first DC power supply module and the second DC power supply module, the connection manner of the first DC power supply sub-modules, the connection manner of the second DC power supply sub-modules, and the switching-on and switching-off of the neutral line switch, which avoids confusion between the previous operating mode and the next operating mode of the energy storage unit, so that the switching of the connection manner of the first DC power supply module and the second DC power supply module is safe and reliable.

The technical effect of the ninth technical solution is basically equivalent to that of the first technical solution, with the difference that the ninth technical solution only relates to how to determine whether the converter device unit has the neutral line.

The technical effect of the tenth technical solution is equivalent to that of any of the first to eighth technical solutions.

### BRIEF DESCRIPTION OF THE DRAWINGS

In order to illustrate the technical solutions of the embodiments of the disclosure more clearly, the drawings used in the description of the embodiments are briefly introduced in the following. It is apparent that the drawings in the following description are some embodiments of the disclosure, and that other drawings may be available to those of ordinary skill in the art according to the drawings without creative labor.
FIG. 1 is a schematic diagram of a power supply system of a first embodiment of the disclosure, where the converter device is a first converter device.
FIG. 2 is a schematic diagram of the power supply system of the first embodiment of the disclosure, where the converter device is a second converter device.
FIG. 3 is a schematic diagram of an energy storage unit of the first embodiment of the disclosure.
FIG. 4 is a schematic diagram of a power supply system of a second embodiment of the disclosure, where the converter device is the first converter device.
FIG. 5 is a schematic diagram of a power supply system of a third embodiment of the disclosure, where the converter device is the first converter device.
FIG. 6 is a schematic diagram of a power supply system of a fourth embodiment of the disclosure, where the converter device is the first converter device.
FIG. 7 is a schematic diagram of a power supply system of a fifth embodiment of the disclosure, where the converter device is the first converter device.

### DESCRIPTION OF REFERENCE NUMERALS

Energy storage device 100; positive output terminal 11; negative output terminal 12; neutral line output terminal 13; energy storage unit 20; first DC power supply module 21; first DC power supply sub-module 211; second DC power supply module 22; second DC power supply sub-module 221; first switch S1; second switch S2; third switch S3; neutral line switch S0; voltage dividing unit 30; voltage dividing resistor R; voltage dividing switch Sr; control unit 40; voltage collector 50; and converter device 200.

### DETAILED DESCRIPTION

The technical solutions in the embodiments of the disclosure would be clearly and completely described below in combination with the drawings in the embodiments of the disclosure. It is apparent that the described embodiments are preferred embodiments of the disclosure and should not be regarded as an exclusion of other embodiments. Based on the embodiments of the disclosure, all other embodiments obtained by those of ordinary skill in the art without creative labor fall within the scope of protection of the disclosure.

In the claims, specification and aforementioned drawings of the disclosure, unless otherwise explicitly limited, the terms "first", "second", "third", or the like, are used to distinguish different objects, and are not used to describe a particular order.

In the claims, specification and aforementioned drawings of the disclosure, unless otherwise explicitly limited, orientation terms, for example, the terms "center", "transverse", "longitudinal", "horizontal", "vertical", "top", "bottom", "inside", "outside", "above", "below", "front", "back", "left", "right", "clockwise", "anti-clockwise", or the like, are used to indicate orientation or positional relationships which are based on the orientation and positional relationships shown in the drawings, and are only for the convenience of recounting the disclosure and simplifying the description, instead of indicating or implying that the device or element referred to necessarily has a specific orientation or is constructed and operated with a specific orientation, and therefore should not be understood as a restriction on the specific scope of protection of the disclosure.

In the claims, specification and aforementioned drawings of the disclosure, unless otherwise explicitly limited, the term "fixed connection" should be understood in a broad sense, i.e., any connection manner that does not involve a displacement relationship or a relative rotation relationship between the two, which includes non-detachable fixed connection, detachable fixed connection, integrated connection, and fixed connection through other devices or elements.

In the claims, specification and aforementioned drawings of the disclosure, the terms "include", "have" and variations thereof are intended to denote "including but not limited to".

### First embodiment

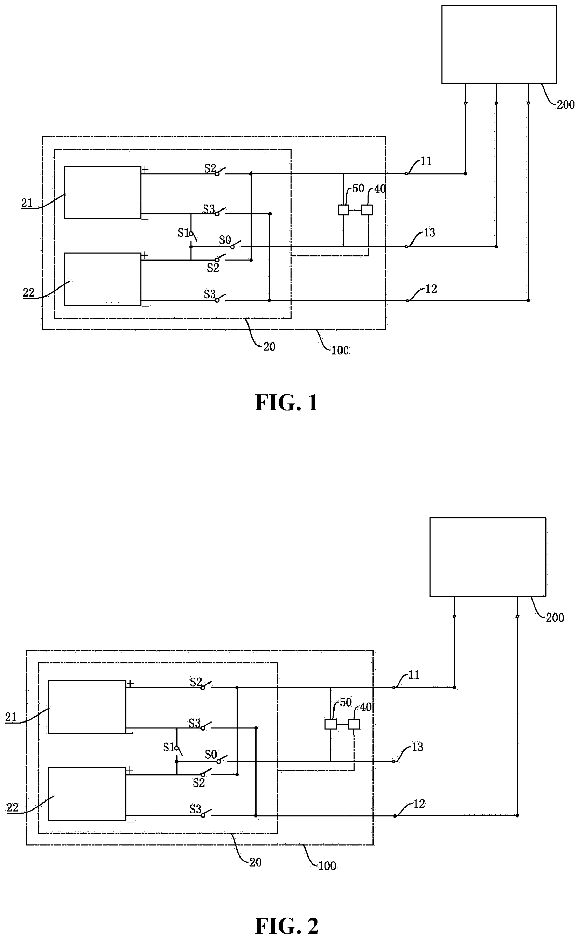

Referring to FIGS. 1-2, FIGS. 1-2 illustrate a power supply system including an energy storage device 100 and a converter device 200. The energy storage device 100 is provided with a positive output terminal 11, a negative output terminal 12 and a neutral line output terminal 13. The converter device 200 is a first converter device 200 or a second converter device 200 electrically coupled to the energy storage device 100. Referring to FIG. 1, the first converter device 200 includes a neutral potential point and is used to be connected to the positive output terminal 11, the negative output terminal 12 and the neutral line output terminal 13. Referring to FIG. 2, the second converter device 200 does not include the neutral potential point and is used to be connected to only the positive output terminal 11 and the negative output terminal 12.

Referring to FIGS. 1-2, the energy storage device 100 includes a connection terminal, an energy storage unit 20, a neutral line switch S0, a voltage collector 50 and a control unit 40.

The connection terminal includes the positive output terminal 11, the negative output terminal 12 and the neutral line output terminal 13. Either the positive output terminal 11 or the negative output terminal 12 is defined as a connection output terminal. Either the positive output terminal 11 or the negative output terminal 12 is defined as a detection output terminal. The connection terminal is an external electrical connection port of the entire energy storage device 100.

The energy storage unit 20 is adapted to be connected to the positive output terminal 11 and the negative output terminal 12, and is further adapted to be connected to the neutral line output terminal 13 through the neutral line switch S0. Specifically, the energy storage unit 20 includes a first DC power supply module 21 and a second DC power supply module 22 with equal voltages. The first DC power supply module 21 and the second DC power supply module 22 are adapted to be connected in series or in parallel. The neutral line switch SO is connected in series between a negative terminal of the first DC power supply module 21 and the neutral line output terminal 13, or between a positive terminal of the second DC power supply module 22 and the neutral line output terminal 13.

The energy storage unit 20 further includes a series-parallel switch module. The series-parallel switch module includes a first switch S1 for connecting the first DC power supply module 21 and the second DC power supply module 22 in series, a second switch S2 for connecting a positive terminal of the first DC power supply module 21 and the positive terminal of the second DC power supply module 22 in parallel, and a third switch S3 for connecting the negative terminal of the first DC power supply module 21 and a negative terminal of the second DC power supply module 22 in parallel.

The first DC power supply module 21 includes N first DC power supply sub-modules 211, and the second DC power supply module 22 includes M second DC power supply sub-modules 221. N and M are positive integers.

The energy storage unit 20 may be in the form of an energy storage box including a battery pack, a first DC/DC transformation unit and a second DC/DC transformation unit. Each energy storage unit 20 is provided with a positive terminal, a negative terminal and a neutral line terminal, which are used to be connected to the positive output terminal 11, the negative output terminal 12 and the neutral line output terminal 13, respectively. Low voltage sides of the first DC/DC transformation unit and the second DC/DC transformation unit are connected to the battery pack, and high voltage sides of the first DC/DC transformation unit and the second DC/DC transformation unit are provided with positive terminals and negative terminals to form the first DC power supply module 21 and the second DC power supply module 22, respectively. In such case, a converter device 200 may correspond to multiple energy storage units 20, and the multiple energy storage units 20 are connected in parallel. Both the series-parallel switch modules and the neutral line switches SO are located in the energy storage box, and the number of neutral line switches SO corresponds to the number of energy storage units 20.

Of course, in another implementation, the energy storage unit 20 may be in the form of an energy storage cabinet including multiple energy storage modules connected in parallel. Each energy storage module is in the form of an energy storage box including a battery pack, the first DC/DC transformation unit and the second DC/DC transformation unit. The low voltage sides of the first DC/DC transformation unit and the second DC/DC transformation unit are connected to the battery pack. Positive terminals of the corresponding first DC/DC transformation unit and the second DC/DC transformation unit in each energy storage module are respectively connected in parallel to form the positive terminals of the first DC power supply module 21 and the second DC power supply module 22. Negative terminals of the corresponding first DC/DC transformation unit and the second DC/DC transformation unit in each energy storage module are respectively connected in parallel to form the negative terminals of the first DC power supply module 21 and the second DC power supply module 22. In such case, the number of energy storage units 20 corresponds to the number of converter devices 200. Both the series-parallel switch module and the neutral line switch SO are located outside the energy storage box, and only one group of series-parallel switch modules and one group of neutral line switches SO are needed to be disposed. The energy storage unit 20 in FIGS. 1-2 is in the form of the energy storage cabinet.

In the practical application, the first DC/DC transformation unit includes N first DC/DC converters, and the second DC/DC transformation unit includes M second DC/DC converters. Input terminals of the first DC/DC converters and the second DC/DC converters are connected to the battery pack. Each of high voltage sides of the first DC/DC converters and the second DC/DC converters is provided with a respective positive terminal and a respective negative terminal. Each of the first DC/DC converter and the second DC/DC converter forms a respective one of the first DC power supply sub-module 211 and the second DC power supply sub-module 221.

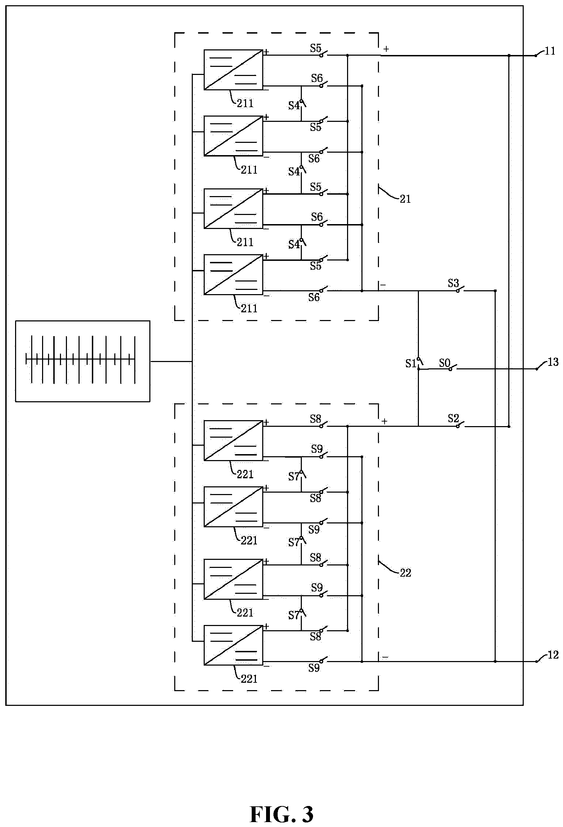

Referring to FIG. 3, when N is greater than 1, the series-parallel switch module includes a fourth switch unit (switch S4 in FIG. 3) for achieving series connection of the first DC power supply sub-modules 211 and a fifth switch unit (switches S5 and S6 in FIG. 3) for achieving parallel connection of the first DC power supply sub-modules 211. When M is greater than 1, the series-parallel switch module includes a seventh switch unit (switch S7 in FIG. 3) for achieving series connection of the second DC power supply sub-modules 221 and an eighth switch unit (switches S8 and S9 in FIG. 3) for achieving parallel connection of the second DC power supply sub-modules 221. It is to be understood that in another implementation, the first DC power supply module 21 may include N (N>1) first DC power supply sub-modules 211, and the second DC power supply module 22 may include one second DC power supply sub-module 221. Alternatively, the first DC power supply module 21 may include one first DC power supply sub-module, and the second DC power supply module 22 may include M (M>1) second DC power supply sub-modules.

The control unit 40 is adapted to: obtain, when the energy storage device 100 is in a shutdown state and the converter device 200 is in a state of charging the energy storage device 100, two port voltages of the energy storage device 100 when a preset condition is satisfied, and determine whether a change of a voltage difference between the two port voltages is within a preset range when the preset condition is satisfied. If the result is yes, the neutral line switch SO is controlled to be switched on; otherwise, the neutral line switch SO is controlled to be switched off. The port voltages are voltages between the neutral line output terminal 13 and the positive output terminal 11 or voltages between the neutral line output terminal 13 and the negative output terminal 12.

In the embodiment, the two port voltages are respectively a maximum voltage value and a minimum voltage value between the neutral line output terminal 13 and the detection output terminal detected by the voltage collector 50 during a set period. If a difference between the maximum voltage value and the minimum voltage value is within the preset range, the neutral line switch SO is controlled to be switched on; otherwise, the neutral line switch SO is controlled to be switched off.

Regarding the converter device 200, in addition to the difference in the existence of the neutral line, there is further a difference in the operation requirement. Some converter devices 200 require high currents and some converter devices 200 require high voltages. Therefore, the energy storage device 100 of the embodiment may further be optimally self-adaptive to the operation requirement of the converter device 200.

The control unit 40 is adapted to obtain an operating voltage and an operating current of the converter device 200, and control, when the operating voltage is greater than a first set value and the energy storage device 100 is in a discharge state, the first switch S1 to be switched on to connect the first DC power supply module 21 and the second DC power supply module 22 in series. The control unit 40 further controls, when the operating current is greater than a second set value and the energy storage device 100 is in the discharge state, the second switch S2 and the third switch S3 to be switched on to connect the first DC power supply module 21 and the second DC power supply module 22 in parallel.

When both N and M are greater than 1, when the operating voltage is greater than the first set value, the energy storage device 100 is in the discharge state and N is greater than 1, the control unit 40 controls the number of the first DC power supply sub-modules 211 and the second DC power supply sub-modules 221 to be connected according to the operating voltage. When the operating current is greater than the first set value, the energy storage device 100 is in the discharge state and M is greater than 1, the control unit 40 controls the number of the first DC power supply sub-modules 211 and the second DC power supply sub-modules 221 to be connected according to the operating current. For example, the converter device 200 requires large voltages but the values of the large voltages are not the same, or the converter device 200 requires large currents but the values of the large currents are not the same, as long as voltages of the first DC power supply module 21 and the second DC power supply module 22 are ensured to be equal, the first DC power supply module 21 may be enabled to have different output currents and output voltages by combining series-parallel connection of the first DC power supply sub-modules 211 in the first DC power supply module 21, and the second DC power supply module 22 may also be enabled to have different output currents and output voltages by combining series-parallel connection of the second DC power supply sub-modules 221 in the second DC power supply module 22.

For example, both the first converter device 200 and the second converter device 200 require a large voltage, but the required large voltage value at this time is less than the voltage value when the first DC power supply sub-modules 211 are connected in series, when the second DC power supply sub-modules 221 are connected in series, and when the first DC power supply module 21 and the second DC power supply module 22 are connected in series. In such case, two of four first DC power supply sub-modules 211 may be connected in series as a group by cooperation of the fourth switch unit and the fifth switch unit, and then the two groups may be connected in parallel to form the first DC power supply module 21 having a second voltage value. Similarly, the second DC power supply module 22 is enabled to output the second voltage value.

The control unit 40 is adapted to shut down the energy storage unit 20 when the operation requirement of the converter device 200 changes, and switch a connection manner of the first DC power supply module 21 and the second DC power supply module 22, a connection manner of the first DC power supply sub-modules 211, a connection manner of the second DC power supply sub-modules 221, and switching-on and switching-off of the neutral line switch SO after the set period according to obtained information (whether the converter device has the neutral line, and the operating voltage and operating current of the converter device).

In the embodiment, a method for an energy storage device 100 to determine whether a converter device 200 connected thereto has a neutral line specifically includes the following operations.

In operation S1, a wiring between the energy storage device 100 and the converter device 200 is completed. The energy storage device 100 is enabled to be in a shutdown state and the converter device 200 is enabled to be in a state of charging the energy storage device 100.

In the operation, the wiring of the energy storage device 100 and the converter device 200 is firstly completed. At this time, the energy storage device 100 does not know whether the converter device 200 has the neutral line, and thus the energy storage device 100 is in the shutdown state to ensure output safety of the energy storage device 100. The energy storage device 100 is charged through the converter device 200, and an output terminal of the energy storage device 100 is also electrified.

In operation S2, two port voltages of the energy storage device 100 when a preset condition is satisfied are obtained, and it is determined whether a change of a voltage difference between the two port voltages is within a preset range when the preset condition is satisfied. If the result is yes, a neutral line switch is controlled to be switched on; otherwise, the neutral line switch is controlled to be switched off.

In the operation, in the embodiment, a voltage value between a neutral line output terminal 13 and a positive output terminal 11 of the energy storage device 100 during a set period is detected by a voltage collector 50 and sent to a control unit 40. The voltage collector 50 always collects the voltage between the neutral line output terminal 13 and the positive output terminal 11. The largest voltage value is a maximum voltage value and the smallest voltage value is a minimum voltage value. The control unit 40 receives the voltage value, compares the difference between the maximum voltage value and the minimum voltage value, and determines whether the difference is within the preset range. If so, it is determined that the converter device 200 connected thereto does not have the neutral line, and the neutral line switch SO is switched off; otherwise, the converter device 200 has the neutral line, and the neutral line switch SO is switched on.

In the embodiment, when the converter device 200 has the neutral line, positive and negative voltages of the converter device 200 are controlled separately, and a port voltage between the neutral line output terminal 13 and a detection output terminal is basically unchanged, that is, the maximum voltage value and the minimum voltage value within the set period are basically equal. When the converter device 200 does not have the neutral line, the difference between the positive and negative voltages of the converter device 200 is stable, and the voltage between the neutral line output terminal 13 and the detection output terminal fluctuates. Therefore, there would be the maximum voltage value and the minimum voltage value within the set period, and the difference between the two would exceed the preset range. In this way, it may be determined that the converter device 200 does not have the neutral line and thus the neutral line switch SO is switched off. Such determination method is simple and easy to implement. The neutral line switch SO would be switched on after the neutral line has been detected, and thus the neutral line output terminal 13 of the energy storage device 100 is conductive; otherwise, the neutral line output terminal 13 is not conductive. In this way, the energy storage device 100 can be matched with the converter device 200 with the neutral line and the converter device 200 without the neutral line, so that the energy storage device 100 may be automatically adapted to different types of converter devices 200 after operation.

In the embodiment, the control unit 40 controls series-parallel switching of a first DC power supply module 21 and a second DC power supply module 22 according to an operating voltage and an operating current of the converter device 200, so that the energy storage device 100 may further be adapted to an operation requirement of the converter device 200. Compared to manually adjusting the series-parallel connection of the first DC power supply module 21 and the second DC power supply module 22, the energy storage device 100 may switch in real time, and the operation is more flexible.

When the converter device 200 is replaced, the requirement of the converter device 200 will change. In such case, the energy storage unit 20 is shut down firstly, and after determining the configuration and requirement of the converter device, the control unit 40 controls to switch a connection manner of the first DC power supply module 21 and the second DC power supply module 22, a connection manner of first DC power supply sub-modules 211, a connection manner of second DC power supply sub-modules 221, and switching-on and switching-off of the neutral line switch S0, which avoids confusion between the previous operating mode and the next operating mode of the energy storage unit 20, so that the switching of the connection manner of each DC power supply module 21 is safe and reliable.

### Second embodiment

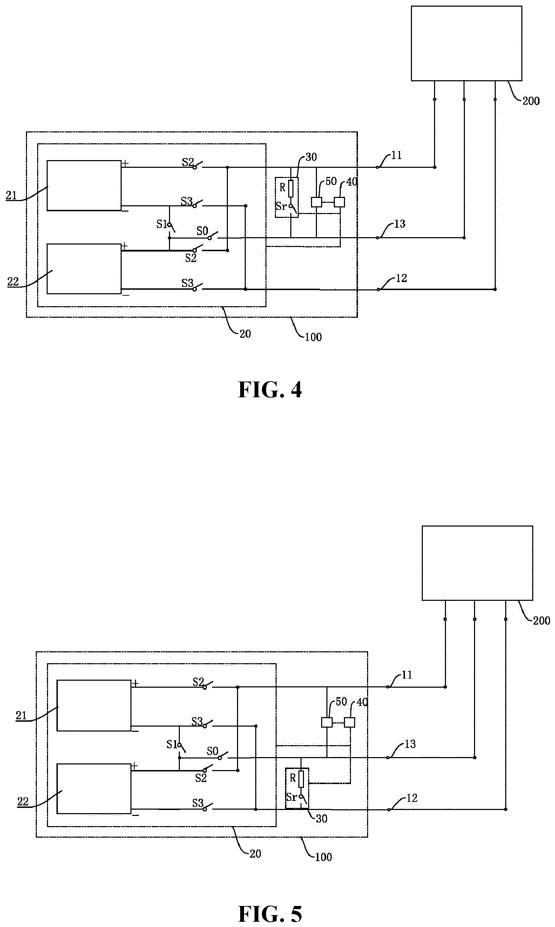

The second embodiment is basically the same as the first embodiment. The difference is that, referring to FIG. 4, a voltage dividing unit 30 and a voltage collector 50 are further included.

The voltage dividing unit 30 is connected in series between the neutral line output terminal 13 and the connection output terminal, and is adapted to establish a path between the neutral line output terminal 13 and the connection output terminal. In the embodiment, both the connection output terminal and the detection output terminal are the positive output terminal 11. The voltage dividing unit 30 includes a voltage dividing resistor R and a voltage dividing switch Sr connected in series. The voltage dividing switch Sr establishes the path between the neutral line output terminal 13 and the connection output terminal when the voltage dividing switch Sr is switched on, and the path between the neutral line output terminal 13 and the connection output terminal does not exist when the voltage dividing switch Sr is switched off.

The voltage collector 50 collects the voltage between the neutral line output terminal 13 and the positive output terminal 11 and transmits the voltage to the control unit 40. The control unit 40 communicates with the series-parallel switch module, the neutral line switch S0, the voltage dividing switch Sr, the voltage collector 50 and the converter device 200.

The control unit 40 is adapted to, when the wiring between the energy storage unit 20 and the converter device 200 is completed, the energy storage unit 20 is in the shutdown state and the converter device 200 is in the state of charging the energy storage unit 20, detect the first voltage between the neutral line output terminal 13 and the positive output terminal 11 of the energy storage unit 20 when the path between the neutral line output terminal 13 and the positive output terminal 11 exists, and the second voltage between the neutral line output terminal 13 and the positive output terminal 11 of the energy storage unit 20 when the path between the neutral line output terminal 13 and the positive output terminal 11 does not exist. If the difference between the first voltage and the second voltage exceeds the first threshold, it is determined that the converter device 200 connected thereto does not have the neutral line (i.e., it is determined that the converter device 200 is the second converter device 200), and the neutral line switch SO is controlled to be switched off. Otherwise, the converter device 200 has the neutral line (it is determined that the converter device 200 is the first converter device 200), and the neutral line switch SO is controlled to be switched on.

The method for the energy storage device 100 to determine whether the converter device 200 connected thereto has the neutral line specifically includes the following operations.

In operation S1, the wiring between the energy storage device 100 and the converter device 200 is completed. The energy storage device 100 is enabled to be in the shutdown state and the converter device 200 is enabled to be in the state of charging the energy storage device 100.

In the operation, the wiring of the energy storage device 100 and the converter device 200 is firstly completed. At this time, the energy storage device 100 does not know whether the converter device 200 has the neutral line, and the energy storage device 100 is in the shutdown state to ensure the output safety of the energy storage device 100. The energy storage device 100 is charged through the converter device 200, and the output terminal of the energy storage device 100 is also electrified.

In operation S2, the first voltage when the path between the neutral line output terminal 13 and the positive output terminal 11 of the energy storage device 100 exists, and the second voltage when the path does not exist, are detected by the voltage collector 50, and are sent to the control unit 40.

In the operation, the voltage collector 50 always collects the voltage between the neutral line output terminal 13 and the positive terminal output terminal 11. When the control unit 40 controls the dividing switch Sr to be switched on, the path between the neutral line output terminal 13 and the positive output terminal 11 is established. When the control unit 40 controls the dividing switch Sr to be switched off, the path between the neutral line output terminal 13 and the positive output terminal 11 is disconnected.

In operation S3, the control unit 40 receives the first voltage and the second voltage, and compares the difference between the first voltage and the second voltage. If the first voltage is less than the second voltage and the difference between the first voltage and the second voltage exceeds the first threshold, it is determined that the converter device 200 connected thereto does not have the neutral line; otherwise, the converter device 200 has the neutral line.

The reason is as follows. When the converter device 200 has the neutral line, the positive and negative voltages of the converter device 200 are controlled separately, and the detected voltage between the neutral line output terminal 13 and the positive output terminal 11 does not change when the path between the neutral line output terminal 13 and the connection output terminal exists or does not exist. When the converter device 200 does not have the neutral line, the difference between the positive and negative voltages of the converter device 200 is stable, and a leakage current would be formed after the path between the neutral line output terminal 13 and the connection output terminal is formed, so that the voltage corresponding to the connection output terminal changes. In the embodiment, correspondingly, the connection output terminal is the positive output terminal 11. After the path between the positive output terminal 11 and the neutral output terminal 13 is formed, the positive voltage decreases due to the leakage current, and the first voltage is less than the second voltage. Therefore, the energy storage device 100 may determine whether the converter device 200 connected thereto has the neutral line by comparing the change of the difference between the first voltage and the second voltage. As can be seen, such determination method is simple to operate and easy to implement.

On the basis of the aforementioned method, the energy storage device 100 switches on the neutral line switch SO when it is determined that the converter device 200 has the neutral line, and switches off the neutral line switch SO when it is determined that the converter device 200 does not have the neutral line. Therefore, the energy storage device 100 is enabled to be adaptive, in a series state, to the converter device 200 configured with the neutral line and the converter device 200 that is not configured with the neutral line.

### Third embodiment

The power supply system of the third embodiment is basically the same as that of the second embodiment. The difference is that, referring to FIG. 5, the connection output terminal is the negative output terminal 12, and the voltage dividing unit 30 of the energy storage device 100 is connected in series between the neutral line output terminal 13 and the negative output terminal 12. When the first voltage is greater than the second voltage and the difference between the first voltage and the second voltage is greater than the first threshold, the control unit 40 determines that the converter device 200 connected thereto does not have the neutral line and controls the neutral line switch SO to be switched off; otherwise, the converter device 200 has the neutral line and the neutral line switch SO is controlled to be switched on.

In the embodiment, after the voltage dividing unit 30 forms the path between the neutral line output terminal 13 and the negative output terminal 12, the negative voltage decreases due to the leakage current, and the voltage between the neutral line output terminal 13 and the negative output terminal 12 decreases. Since the difference between the positive voltage and the negative voltage does not change, the positive voltage increases, and the first voltage is greater than the second voltage.

### Fourth embodiment

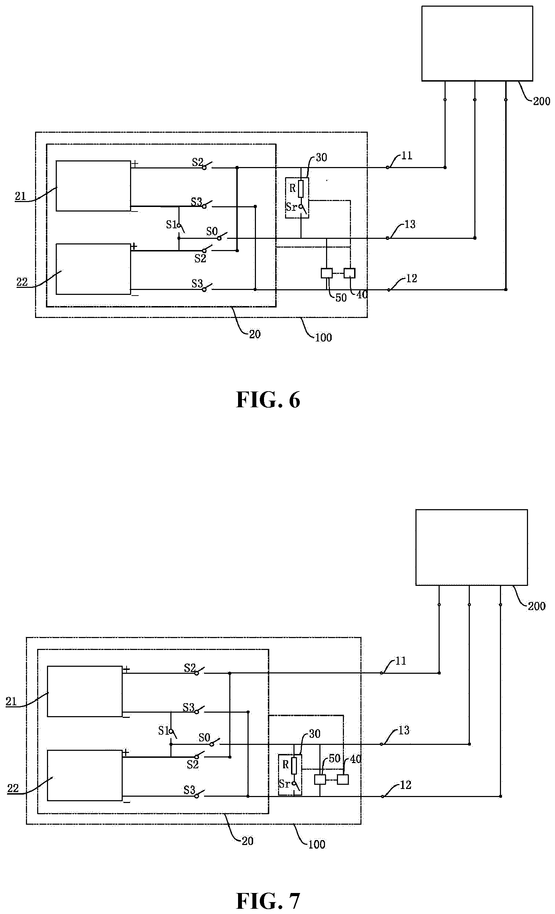

The power supply system of the fourth embodiment is basically the same as that of the second embodiment. Referring to FIG. 6, the difference is that the detection output terminal is the negative terminal output 12, that is, the voltage collector 50 of the energy storage device 100 collects the first voltage when the path between the neutral line output terminal 13 and the negative output terminal 12 exists, and collects the second voltage when the path does not exist. When the first voltage is greater than the second voltage and the difference between the first voltage and the second voltage is greater than the first threshold, the control unit 40 determines that the converter device 200 connected thereto does not have the neutral line and controls the neutral line switch SO to be switched off; otherwise, the converter device 200 has the neutral line and the neutral line switch SO is controlled to be switched on.

In the embodiment, after the voltage dividing unit 30 forms the path between the neutral line output terminal 13 and the positive output terminal 11, the positive voltage decreases due to the leakage current. Since the difference between the positive voltage and the negative voltage does not change, the voltage between the neutral line output terminal 13 and the negative output terminal 12 increases, and the first voltage is greater than the second voltage.

### Fifth embodiment

The power supply system of the fifth embodiment is basically the same as that of the fourth embodiment. The difference is that, referring to FIG. 7, the connection output terminal is the negative output terminal, and the voltage dividing unit 30 of the energy storage device 100 is connected in series between the neutral line output terminal 13 and the negative output terminal 12. When the first voltage is less than the second voltage and the difference between the first voltage and the second voltage is greater than the first threshold, the control unit 40 determines that the converter device 200 connected thereto does not have the neutral line and controls the neutral line switch SO to be switched off; otherwise, the converter device 200 has the neutral line and the neutral line switch SO is controlled to be switched on.

In the embodiment, after the voltage dividing unit 30 forms the path between the neutral line output terminal 13 and the negative output terminal 12, the negative voltage decreases due to the leakage current. Therefore, the voltage between the neutral line output terminal 13 and the negative output terminal 12 decreases, and the first voltage is less than the second voltage.

The aforementioned description of the specification and the embodiments is used to explain the scope of protection of the disclosure, but does not constitute a limitation of the scope of protection of the disclosure. Through the enlightenment of the disclosure or the aforementioned embodiments, all the modifications, equivalent substitutions or other improvements to the embodiments of the disclosure or some of the technical features thereof that can be obtained by those of ordinary skill in the art by combining common knowledge, ordinary technical knowledge in the art and/or the related art through logical analysis, inference or limited experiments shall be included in the scope of protection of the disclosure.

## Claims

1. An energy storage device (100) configured to be connected to a converter device (200), comprising:
a connection terminal, wherein the connection terminal comprises a positive output terminal (11), a negative output terminal (12) and a neutral line output terminal (13);
a neutral line switch (SO);
an energy storage unit (20), wherein the energy storage unit (20) is adapted to be connected to the positive output terminal (11) and the negative output terminal (12), and is further adapted to be connected to the neutral line output terminal (13) through the neutral line switch (SO); and
a control unit (40), wherein the control unit (40) is adapted to: obtain, when the energy storage device (100) is in a shutdown state and the converter device (200) is in a state of charging the energy storage device (100), two port voltages of the energy storage device (100) when a preset condition is satisfied, and determine whether a change of a voltage difference between the two port voltages is within a preset range when the preset condition is satisfied; if a result is yes, perform control to switch on the neutral line switch (SO); otherwise, perform control to switch off the neutral line switch (S0);
wherein the port voltages are voltages between the neutral line output terminal (13) and the positive output terminal (11) or voltages between the neutral line output terminal (13) and the negative output terminal (12).

2. The energy storage device (100) of claim 1, further comprising a voltage collector (50);
wherein either the positive output terminal (11) or the negative output terminal (12) is defined as a detection output terminal; and
the two port voltages are respectively a maximum voltage value and a minimum voltage value between the neutral line output terminal (13) and the detection output terminal detected by the voltage collector (50) during a set period; wherein if a difference between the maximum voltage value and the minimum voltage value is within the preset range, the neutral line switch (S0) is controlled to be switched on; otherwise, the neutral line switch (S0) is controlled to be switched off.

3. The energy storage device (100) of claim 1, further comprising a voltage collector (50) and a voltage dividing unit (30);
wherein either the positive output terminal (11) or the negative output terminal (12) is defined as a detection output terminal, either the positive output terminal (11) or the negative output terminal (12) is defined as a connection output terminal, and the voltage dividing unit (30) is connected in series between the neutral line output terminal (13) and the connection output terminal and is adapted to establish a path between the neutral line output terminal (13) and the connection output terminal; and
the two port voltages are respectively a first voltage between the neutral line output terminal (13) and the detection output terminal, which is detected by the voltage collector (50) when the path between the neutral line output terminal (13) and the connection output terminal exists, and a second voltage between the neutral line output terminal (13) and the detection output terminal, which is detected by the voltage collector (50) when the path between the neutral line output terminal (13) and the connection output terminal does not exist; wherein if a difference between the first voltage and the second voltage is within the preset range, the neutral line switch (S0) is switched on; otherwise, the neutral line switch (S0) is switched off.

4. The energy storage device (100) of claim 3, wherein the voltage dividing unit (30) comprises a voltage dividing resistor (R) and a voltage dividing switch (Sr) connected in series; the voltage dividing switch (Sr) establishes the path between the neutral line output terminal (13) and the connection output terminal when the voltage dividing switch (Sr) is switched on, and the path between the neutral line output terminal (13) and the connection output terminal does not exist when the voltage dividing switch (Sr) is switched off.

5. The energy storage device (100) of claim 4, wherein when the detection output terminal is the positive output terminal (11), if the connection output terminal is the positive output terminal (11), the first voltage is less than the second voltage, and the difference between the first voltage and the second voltage is not within the preset range, the control unit (40) controls the neutral line switch (S0) to be switched off; otherwise, the control unit (40) controls the neutral line switch (S0) to be switched on; and if the connection output terminal is the negative output terminal (12), the first voltage is greater than the second voltage, and the difference between the first voltage and the second voltage is greater than a first threshold, the control unit (40) controls the neutral line switch (S0) to be switched off; otherwise, the control unit (40) controls the neutral line switch (S0) to be switched on; and
when the detection output terminal is the negative output terminal (12), if the connection output terminal is the positive output terminal (11), the first voltage is greater than the second voltage, and the difference between the first voltage and the second voltage is greater than the first threshold, the control unit (40) controls the neutral line switch (S0) to be switched off; otherwise, the control unit (40) controls the neutral line switch (S0) to be switched on; and if the connection output terminal is the negative output terminal (12), the first voltage is less than the second voltage, and the difference between the first voltage and the second voltage is greater than the first threshold, the control unit (40) controls the neutral line switch (S0) to be switched off; otherwise, the control unit (40) controls the neutral line switch (S0) to be switched on.

6. The energy storage device (100) of any one of claims 2-5, wherein the energy storage unit (20) comprises a first direct-current, DC, power supply module (21) and a second DC power supply module (22) with equal voltages;
the first DC power supply module (21) and the second DC power supply module (22) are adapted to be connected in series or in parallel, and the neutral line switch (S0) is connected in series between a negative terminal of the first DC power supply module (21) and the neutral line output terminal (13), or between a positive terminal of the second DC power supply module (22) and the neutral line output terminal (13); and
the control unit (40) is further adapted to switch on the neutral line switch (S0) when the first DC power supply module (21) and the second DC power supply module (22) are connected in series and it is determined that the converter device (200) has a neutral line.

7. The energy storage device (100) of claim 6, wherein the energy storage unit (20) further comprises a series-parallel switch module;
wherein the series-parallel switch module comprises a first switch (S1) for connecting the first DC power supply module (21) and the second DC power supply module (22) in series, a second switch (S2) for connecting a positive terminal of the first DC power supply module (21) and the positive terminal of the second DC power supply module (22) in parallel, and a third switch (S3) for connecting the negative terminal of the first DC power supply module (21) and a negative terminal of the second DC power supply module (22) in parallel; and
the control unit (40) is adapted to obtain an operating voltage and an operating current of the converter device (200), and control, when the operating voltage is greater than a first set value and the energy storage device (100) is in a discharge state, the first switch (S1) to be switched on to connect the first DC power supply module (21) and the second DC power supply module (22) in series; and the control unit (40) further controls, when the operating current is greater than a second set value and the energy storage device (100) is in the discharge state, the second switch (S2) and the third switch (S3) to be switched on to connect the first DC power supply module (21) and the second DC power supply module (22) in parallel.

8. The energy storage device (100) of claim 7, wherein the first DC power supply module (21) comprises N first DC power supply sub-modules (211), the second DC power supply module (22) comprises M second DC power supply sub-modules (221), and N and M are positive integers, wherein the series-parallel switch module comprises, when N is greater than 1, a fourth switch unit for achieving series connection of the first DC power supply sub-modules (211) and a fifth switch unit for achieving parallel connection of the first DC power supply sub-modules (211), and the series-parallel switch module comprises, when M is greater than 1, a seventh switch unit for achieving series connection of the second DC power supply sub-modules (221) and an eighth switch unit for achieving parallel connection of the second DC power supply sub-modules;
when the operating voltage is greater than the first set value, the energy storage device (100) is in the discharge state and N is greater than 1, the control unit (40) controls a number of the first DC power supply sub-modules (211) and the second DC power supply sub-modules (221) to be connected according to the operating voltage;
when the operating current is greater than the first set value, the energy storage device (100) is in the discharge state and M is greater than 1, the control unit (40) controls the number of the first DC power supply sub-modules (211) and the second DC power supply sub-modules (221) to be connected according to the operating current; and
the control unit (40) is adapted to shut down the energy storage unit (20) when an operation requirement of the converter device (200) changes, and switch, after a set period according to obtained information, a connection manner of the first DC power supply module (21) and the second DC power supply module (22), a connection manner of the first DC power supply sub-modules (211), a connection manner of the second DC power supply sub-modules (221), and switching-on and switching-off of the neutral line switch (S0).

9. A method for an energy storage device (100) to determine whether a converter device (200) connected thereto has a neutral line, wherein the energy storage device (100) is equipped with a positive output terminal (11), a negative output terminal (12) and a neutral line output terminal (13), and the method comprises:
completing a wiring between the energy storage device (100) and the converter device (200); and
obtaining, when the energy storage device (100) is in a shutdown state and the converter device (200) is in a state of charging the energy storage device (100), two port voltages of the energy storage device (100) when a preset condition is satisfied, and determining whether a change of a voltage difference between the two port voltages is within a preset range when the preset condition is satisfied; if a result is yes, performing control to switch on the neutral line switch (S0); otherwise, performing control to switch off the neutral line switch (S0); wherein the port voltages are voltages between the neutral line output terminal (13) and the positive output terminal (11) or voltages between the neutral line output terminal (13) and the negative output terminal (12).

10. A power supply system, comprising:
an energy storage device (100) of any one of claims 1-8; and
a converter device (200) which is a first converter device (200) or a second converter device (200) electrically coupled to the energy storage device (100), wherein the first converter device (200) comprises a neutral potential point, and the second converter device (200) does not comprise the neutral potential point.
